(19) **Europäisches Patentamt / European Patent Office / Office européen des brevets**

(11) **EP 4 429 048 B1**

(12) **EUROPEAN PATENT SPECIFICATION**

(45) Date of publication and mention
of the grant of the patent:
**06.05.2026 Bulletin 2026/19**

(21) Application number: **23218834.2**

(22) Date of filing: **20.12.2023**

(51) International Patent Classification (IPC):
*H01S 3/06* (2006.01)    *H01S 3/094* (2006.01)
*H01S 3/0941* (2006.01)    *H01S 3/102* (2006.01)
*H01S 3/08045* (2023.01)    *H01S 5/00* (2006.01)
*H01S 3/08* (2023.01)

(52) Cooperative Patent Classification (CPC):
**H01S 3/0941; H01S 3/061; H01S 3/094084;**
**H01S 3/1022;** H01S 3/0606; H01S 3/08045;
H01S 3/08072; H01S 5/005

(54) **METHOD FOR SYMMETRIZING SINGLE-SIDED PUMP LASER PROFILES**

VERFAHREN ZUR SYMMETRIERUNG EINSEITIGER PUMPLASERPROFILE

PROCÉDÉ DE SYMÉTRISATION DE PROFILS DE LASER DE POMPE MONOFACE

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR

(30) Priority: **07.03.2023 US 202318179442**

(43) Date of publication of application:
**11.09.2024 Bulletin 2024/37**

(73) Proprietor: **L3Harris Technologies, Inc.**
**Melbourne, FL 32919 (US)**

(72) Inventors:
• **HUBBARD, William J.**
**Meredith, 03253 (US)**
• **GORVEATT, William J.**
**Londonberry, 03053 (US)**
• **TOBEY, Alan E.**
**Billerica, 01821 (US)**

(74) Representative: **Schmidt, Steffen J.**
**Wuesthoff & Wuesthoff**
**Patentanwälte und Rechtsanwalt PartG mbB**
**Schweigerstrasse 2**
**81541 München (DE)**

(56) References cited:
US-A1- 2023 028 158    US-B1- 8 320 425

• WALMSLEY IAN A: "Non-edge-ray design: improved optical pumping of lasers", OPTICAL ENGINEERING, vol. 43, no. 7, July 2004 (2004-07-01), 1000 20th St. Bellingham WA 98225-6705 USA, pages 1511, XP093170093, ISSN: 0091-3286, DOI: 10.1117/1.1751400
• KOSHEL R ET AL: "Diode Side Pumping of an Nd:YAG Laser Rod with a Nonimaging Pump Cavity", OSA PROCEEDINGS OF THE INTERNATIONAL OPTICAL DESIGN CONFERENCE, 1994, pages NISI.304, XP093171163, DOI: 10.1364/IODC.1994.NISI.304
• KOSHEL R ET AL: "Modeling of the gain distribution for diode pumping of a solid-state laser rod with nonimaging optics", APPLIED OPTICS, vol. 32, no. 9, 20 March 1993 (1993-03-20), US, pages 1517, XP093171414, ISSN: 0003-6935, DOI: 10.1364/AO.32.001517
• LIANG ET AL: "Diode pumping of a solid-state laser rod by a two-dimensional CPC-elliptical cavity with intervening optics", OPTICS COMMUNICATIONS, ELSEVIER, AMSTERDAM, NL, vol. 275, no. 1, 10 May 2007 (2007-05-10), pages 104 - 115, XP022070323, ISSN: 0030-4018, DOI: 10.1016/J.OPTCOM.2007.02.024
• YI JONGHOON ET AL: "Diode-Pumped Nd:YAG Rod Laser with Single-Side Pumping Geometry", JOURNAL OF THE KOREAN PHYSICAL SOCIETY, vol. 57, no. 2(1), 13 August 2010 (2010-08-13), Seoul, pages 355 - 358, XP093170007, ISSN: 0374-4884, DOI: 10.3938/jkps.57.355

EP 4 429 048 B1

## Description

### Technical Field

The present disclosure relates to laser devices, and more particularly, to a method for making a single-sided pumped laser device having a symmetrical absorption pump profile within a laser medium body.

### Background

Laser devices have grown in usefulness, particularly in industrial, medical and military applications. Diode pumped laser devices are power efficient and solid-state with a long shelf-life.

Laser devices may be single pumped on one side of the laser medium body, or double pumped along multiple axes of the laser medium body to increase radial symmetry. A single pumped laser device as compared to a double pumped laser device is more cost efficient since less components are required.

However, a drawback of a single pumped laser device is that the pump light distribution within the laser medium body can lead to an asymmetric pattern relative to a centerline (i.e., longitudinal axis) of the laser medium body. Asymmetry of the pump light distribution within the laser medium body can be inefficient and lead to sub-optimal laser mode performance. Examples for single-sided pumped laser devices are disclosed in Walmsley Ian A: "Non-edge-ray design: improved optical pumping of lasers", Optical Engineering, vol. 43, no. 7, 1 July 2004, page 1511; Koshel R ET AL: "Diode Side Pumping of an Nd:YAG Laser Rod with a Nonimaging Pump Cavity", International Optical Design Conference, 1 January 1994, page NISL304; Koshel R ET AL: "Modeling of the gain distribution for diode pumping of a solid-state laser rod with nonimaging optics", Applied Optics, vol. 32, no. 9, 20 March 1993, page 1517; LIANG ET AL: "Diode pumping of a solid-state laser rod by a two-dimensional CPC-elliptical cavity with intervening optics", OPTICS COMMUNICATIONS, ELSEVIER, AMSTERDAM, NL, vol. 275, no. 1, 10 May 2007, pages 104-115; and Yi Jonghoon ET AL: "Diode-Pumped Nd: YAG Rod Laser with Single-Side Pumping Geometry", Journal of the Korean Physical Society, vol. 57, no. 2(1), 13 August 2010, pages 355-358.

Further examples for single-sided pumped laser devices are disclosed in US 8 320 425 B1 and US 2023/028158 A1.

### Summary

The invention is defined by independent claims 1 and 9. Further embodiments of the invention are defined by the dependent claims.

An example method for making a single-sided pumped laser device may include determining an absorption coefficient for a laser medium body, determining divergence angles of pump light from a laser pump to be directed at a side of the laser medium body, and determining initial relative spacings of at least one reflector for the pump light with respect to the laser medium body and the laser pump. A merit function defining a desired absorption profile of the pump light passing through the laser medium body may be generated. The method may further include using a processor and an associated memory to operate an optical model based on the merit function and the determined pump light absorption coefficient, divergence angles and initial relative spacings to determine a curvature of the at least one reflector, and adjusted relative spacings among the laser medium body, the laser pump, and the at least one reflector. The laser medium body, the laser pump, and the at least one reflector may be assembled according to the determined curvature of the at least one reflector and the adjusted relative spacings to make the single-sided pumped laser device.

The merit function may include a plurality of target absorption values defining the desired absorption profile.

The optical model may determine a plurality of computed absorption profiles, with each computed absorption profile comprising a plurality of computed absorption values corresponding to the plurality of target absorption values.

The optical model may determine the plurality of computed absorption profiles while varying curvature of the at least one reflector and varying relative spacings among the laser medium body, the laser pump and the at least one reflector.

The merit function may compare, for each computed absorption profile, the plurality of computed absorption values to the plurality of target absorption values.

The merit function may determine, for each computed absorption profile, a difference between the plurality of computed absorption values and the corresponding plurality of target absorption values, with the differences for each computed absorption profile being summed together to define a respective merit function value.

The optical model may define a plurality of respective merit function values ranging from high to low, with the single-sided pumped laser device being assembled using the curvature of the at least one reflector and the relative spacings among the laser medium body, the laser pump and the at least one reflector for the merit function value having the lowest value.

The laser pump may include a laser diode. The laser medium body may include one of a laser rod having a cylindrical shape and a laser slab having a rectangular shape.

The single-sided pumped laser device may be configured to operate within a laser range finder. The desired absorption profile may be symmetrical to a centerline of the laser medium body.

Yet another aspect is directed to a non-transitory computer readable medium for operating a computing device comprising a display and processor coupled to the display, and with the non-transitory computer readable medium having a plurality of computer executable instructions for causing the processor to perform steps as described above.

## Brief Description of the Drawings

FIG. 1A is a schematic block diagram side view of a single-sided pumped laser device in which various aspects of the disclosure may be implemented.

FIG. 1B is a schematic block diagram end view of the single-sided pumped laser device illustrated in FIG. 1A.

FIG. 2 is a flow diagram on a method for making the single-sided pumped laser device illustrated in FIGS. 1A and 1B.

FIG. 3 is a schematic block diagram of a laser pump cavity for the single-sided pumped laser device illustrated in FIGS. 1A and 1B with additional reflector configurations.

FIG. 4 is a plot of normalized intensity for forward and backward round-trip propagation within the laser medium body illustrated in FIG. 3.

FIG. 5 is a plot showing a figure-of-merit for asymmetric laser pump absorption within the laser medium body illustrated in FIG. 3.

FIG. 6 is a plot showing the pump energy absorbed versus a number of round-trips through the laser medium body illustrated in FIG. 3.

FIG. 7 is a cross-sectional view of the laser medium body illustrated in FIG. 3 depicting a radially-symmetric and intensity varying pump mode.

FIG. 8 is a schematic block diagram of the resonator components to be used by the optical model for the single-sided pumped laser device illustrated in FIGS. 1A and 1B.

FIG. 9 is a plot of the absorbed flux for the laser medium body illustrated in FIG. 8 after operating the optical model based on the merit function.

## Detailed Description

The present description is made with reference to the accompanying drawings, in which exemplary embodiments are shown. However, many different embodiments may be used, and thus the description should not be construed as limited to the particular embodiments set forth herein. Rather, these embodiments are provided so that this disclosure will be thorough and complete. Like numbers refer to like elements throughout, and prime notations may be used to indicate similar elements in different embodiments.

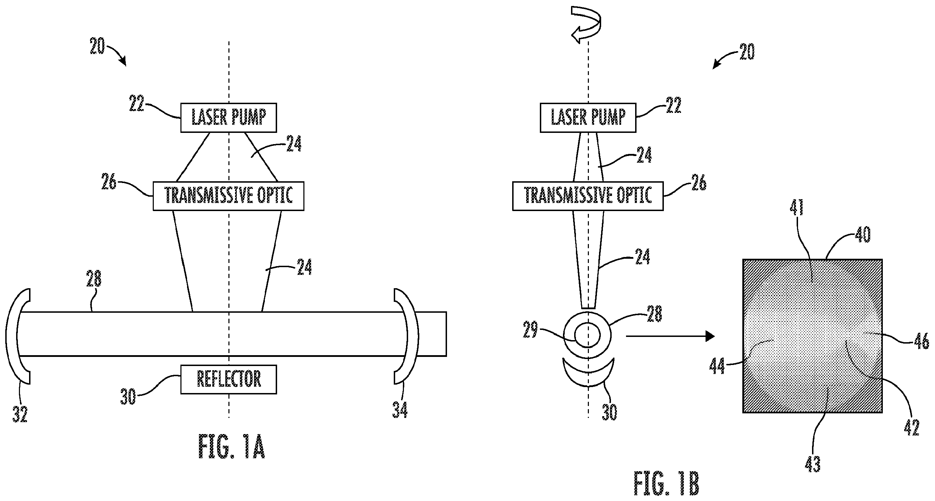

Referring initially to FIGS. 1A and 1B, a single-sided pumped laser device **20** will be discussed. A side view of the single-sided pumped laser device **20** is in FIG. 1A, and a corresponding end view is in FIG. 1B. The end view is along a longitudinal axis of the laser medium body **28**. The laser medium body **28** is configured as a rod having a cylindrical shape. Alternatively, the laser medium body **28** may be configured as a slab having a rectangular shape.

The single-sided pumped laser device **20** includes a laser pump **22** that emits pump light **24** towards the laser medium body **28**. The laser pump **22** may be configured as a laser diode that transfers energy into the laser medium body **28**. The energy is absorbed in the laser medium body **28,** and produces excited states in its dopant atoms. When the number of particles in one excited state exceeds the number of particles in the ground state or a less-excited state, population inversion is achieved. In this condition, a stimulated emission can take place and the laser medium body **28** acts as a laser. The power of the laser pump **22** needs to be sufficient to achieve the lasing threshold of the laser.

The pump light **24** may pass through an optional transmissive optic or lens **26** that redirects the pump light **24** towards the laser medium body **28**. Based on an absorption coefficient of the laser medium body **28,** the pump light **24** is partially absorbed. The pump light **24** that is not absorbed passes through the laser medium body **28,** and is received by at least one reflector **30.** The reflector **30** reflects the received pump light back into the laser medium body **28.** On one end of the laser medium body **28** is a high-reflectance mirror **32,** and on the opposite end is an output coupler **34.**

In an example embodiment, the single-sided pumped laser device **20** may be configured to operate within a hand-held laser rangefinder. Since the single-sided pumped laser device **20** is single pumped as compared to double pumped, it is ideal from a cost-savings standpoint since less components are required. However, a drawback of a single-sided pumped laser device is that the laser mode (i.e., pump light distribution) within the laser medium body **28** can lead to an asymmetric pattern relative to a centerline (i.e., longitudinal axis) of the laser medium body **28.** A representation of a cross-sectional view **40** of the laser medium body **28** illustrates an asymmetrical pump light distribution pattern within a transverse plane along the longitudinal axis.

Within the cross-sectional view **40** of the laser medium body **28,** pump irradiance has the highest concentration at point **42** which is not radially centered within the laser medium body **28.** Pump irradiance is the flux of radiant energy per unit area that is normal to the direction of flow of radiant energy through the laser medium body **28.** The concentration of pump irradiance gradually reduces but continues throughout sections **44** and **46,** whereas the concentration of pump irradiance in sections **41** and **43** is close to zero.

Asymmetry of the pump light distribution within the laser medium body **28** can lead to inefficiency and sub-optimal laser mode performance through thermal-optic distortions (thermal wedge) and deleterious spatial pumping outside of the desired laser mode **22.** A profile of the pump light distribution appears as an asymmetrical bow tie shape within the cross-sectional view **40** of the laser medium body **28.**

Asymmetry of the pump light distribution also produces and selectively distributes waste heat in unwanted regions within the laser medium. Pump irradiance excites the ions within the laser medium body **28.** As pump laser excitation occurs, mechanical stresses are introduced within the laser medium body **28.** As the laser medium body **28** heats up, its properties change. This causes a thermo-optical wedge where it would emulate a wedged laser medium body **28.** The effective wedge prism bends the laser beam within the laser medium body and therefore misaligns a resonant laser cavity **28** instead of allowing the laser beam to oscillate along a predetermined aligned path. This in turn causes misalignment with the high-reflectance mirror **32** and the output coupler **34.**

As will be discussed in greater detail below, a method for symmetrizing pump light distribution within the single-sided pumped laser device **20** is provided. An optical model, such as Zemax OpticStudio®, is used to model a profile of the pump light distribution based on the resonator components within the single-sided pumped laser device **20.** The resonator components include all of the elements illustrated in the single-sided pumped laser device **20.** The optical model uses a merit function to correct for pump light distribution asymmetry by determining component tilts, spacings and surface shape modifications of the resonator components within the single-sided pumped laser device **20.**

The merit function includes target absorption values defining a desired symmetrical absorption profile representing an absorbed flux of the laser beam passing through the laser medium body **28.** The optical model determines a plurality of computed absorption profiles, with each computed absorption profile comprising a plurality of computed absorption values corresponding to the plurality of target absorption values. The plurality of computed absorption profiles are determined while varying curvature of the reflector **30** and varying relative spacings and tilts among the laser medium body **28,** the laser pump **22** and the at least one reflector **30.**

The optical model iteratively computes the absorption values using different permutations of tilts, spacings, index of refractions, and surface shape modifications of the resonator components. The single-sided pumped laser device **20** is assembled using the tilts, spacings and surface shape modifications of the resonator components that generate a computed absorption profile that more closely matches the desired absorption profile.

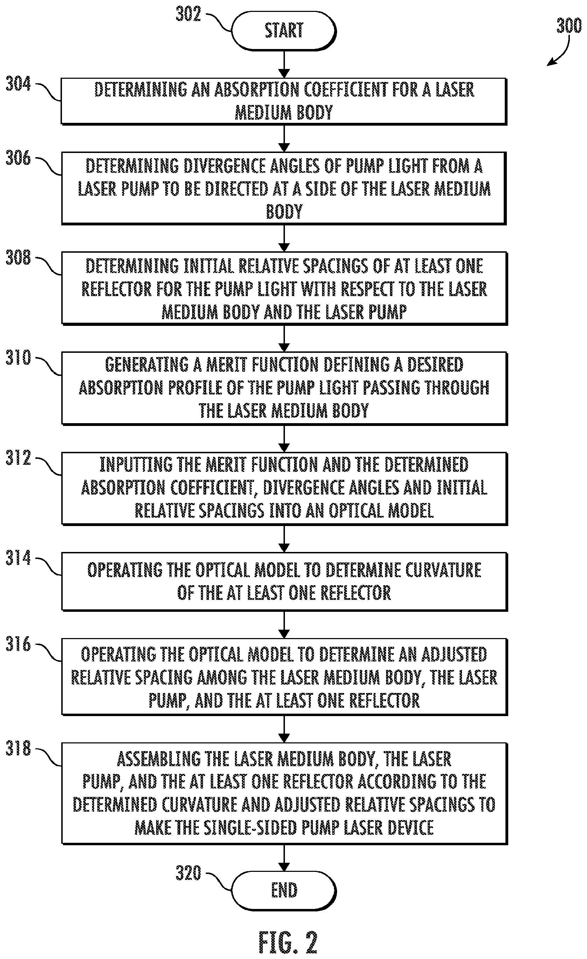

Referring now to FIG. 2, a flow diagram **300** on a method for making the single-sided pumped laser device **20** will be discussed. From the start (Block **302**), a laser absorption coefficient is determined at Block **304** for the laser medium body **28.** The laser absorption coefficient describes the intensity attenuation of light passing through a material.

The laser medium width-normalized absorption coefficient (herein after referred to as absorption coefficient) ranges from 0 to infinity. A laser absorption coefficient of infinity means all of the energy of the pump light **24** from the laser pump **22** is absorbed by the laser medium body **28,** whereas a laser absorption coefficient of 0 means that all of the energy of the pump light **24** passes through the laser medium body **28.** For discussion purposes, the laser absorption coefficient is 0.5 for the laser medium body **28.**

Divergence angles of the beam (i.e., pump light **24**) from the laser pump **22** to be directed at a side of the laser medium body **28** is determined at Block **306.** Beam divergence is an angular measure of the increase in beam diameter or radius with distance from the optical aperture from which the beam was emitted. A laser diode, for example, emits pump light **24** having an elliptical cross-section shape. The y-axis with a large divergence angle is called the fast axis, and the x-axis with a smaller divergence angle is called the slow axis.

Initial relative spacings of the reflector **30** with respect to the laser medium body **28** and the laser pump **22** are determined at Block **308.** The initial relative spacings is a starting point. When the single-sided pumped laser device **20** is configured to operate within a laser rangefinder, for example, the initial relative spacings are based on what would be permitted within the intended size or dimensions of the laser rangefinder.

A merit function is generated at Block **310** to define a desired absorption profile of the pump light **24** passing through the laser medium body **28.** The desired absorption profile is symmetrical relative to a centerline of the laser medium body **28.** As will be discussed in greater detail below, the merit function comprises a plurality of target absorption values defining the desired absorption profile.

At Block **312,** the merit function and the determined absorption coefficient, divergence angles and initial relative spacings are input into the optical model. A computing device comprising a processor and an associated memory is operated at Block **314** to determine a curvature of the reflector **30** and at Block **316** to determine adjusted relative spacings among the laser medium body **28,** the laser pump **22,** and the reflector **30.** If the single-sided pumped laser device **20** includes the optional transmissive optic **26,** then the curvature of the transmissive optic **26** would also be determined, as well as determining adjusted relative spacings taking into account the transmissive optic **26.**

The laser medium body **28,** the laser pump **22,** and the reflector **30** are assembled at Block **318** according to the determined curvature of the reflector and the adjusted relative spacings to make the single-sided pumped laser device. Example curvatures and spacings will be discussed in more detail below. The method ends at Block **320.**

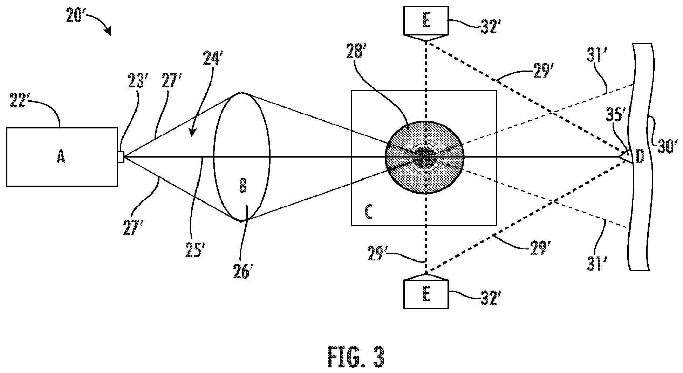

Referring now to FIG. 3, a single-sided pumped laser device **20'** with additional reflectors in accordance with the claimed invention will be discussed in greater detail. An axis of the laser beam is along the longitudinal axis of the laser medium body **28'**(axis is not shown as it project into and out of the page), and is located at the confluence of the solid and dotted lines. The cross-sectional view of the laser medium body **C** depicts a radially-symmetric and intensity varying pump mode.

The block labeled **A** is the laser pump **22'** with an emitter element **23'** providing the pump light **24'**. Optic element B is a transmissive optic **26'** that redirects the pump light **24'** output from the emitter element **23'** into the laser medium body **28'.** The laser medium body **28'** is labeled element **C.**

The pump light **24'** that passes through the laser medium body **28'** is reflected by reflector **D,** which is the main reflector **30'** for recirculating the pump light within the laser medium body **28'.** Reflector **D** may have an arbitrary shape, such as continuous or discrete freeform shapes.

Reflector **D** includes a triangle reflector point **35'** so that a portion of the reflected pump light is directed to ancillary reflectors **E** instead of directly back into the laser medium body **28'.** The ancillary reflectors **E** may also be referred to as ancillary reflectors **32'.** The ancillary reflectors **E** may likewise have an arbitrary shape.

The pump laser axis corresponds to the solid line **25'** that travels from the emitter element **23'** through the transmissive optic element **B** and the laser medium body **C** to be reflected by the triangle reflector point **35'** on reflector **D.** The solid lines **27** indicate marginal rays or pump angular extent. The dashed lines **29** and the dashed lines **31** indicate notional pump recirculation paths.

A desired characteristic of the pump profile formed within the laser medium body **C** is to be radially-symmetric, and to overlap spatially with the desired laser mode. The pump profile refers to the distribution of energy within the laser medium body **C.**

A desired laser mode is the fundamental transverse mode which is designated as $TEM_{00}$, where the subscript 00 indicates a continuous beam profile without nodes. TEM stands for transverse electromagnetic and refers to the form of the standing waves. The $TEM_{00}$ mode has a bell-shaped Gaussian curve.

The pump laser mode refers to the distribution of the pump light within the laser medium body **C.** The distribution of the pump light is desired to be transversely symmetrical to a centerline of the laser medium body **C.** As noted above, asymmetry of the pump light distribution within the laser medium body **C** can lead to inefficiency and sub-optimal laser mode performance. To provide optimal efficiency, a profile of the pump mode is to spatially overlap a profile of the resultant spatial distribution for the laser mode.

The laser pump **A** is selected and characterized such that its divergence properties are known. Transmissive optic **B** is selected based upon desire pump profile characteristics resulting from the optical effect of the geometry of the laser medium body **C.** The index of refraction, surface curvature and distance of transmissive optic **B** is relative to the laser pump **A** and the laser medium body **C.** The transmissive optic **B** optical properties and distance will depend upon the cross-sectional shape of the laser medium body **C** and the mode size desired within the laser medium body **C** with consideration given to any space constraints.

Spacing of the reflector **D** relative to the laser medium body **C** and its shape is initially designed such that the backward propagating rays are incident within the laser medium body **C.** A portion of the pump light which is incident on the reflector **D** is reflected such that ancillary reflectors E direct the residual pump light along the vertical axis forming a more complete laser mode overlap.

Furthermore, an axis of the emitter elements 23' (only one element is shown in the diagram as the emitter axis is in and out of the page) may be skewed or tilted relative to the laser axis to effect a broader vertical distribution of energy for greater mode-filling properties, particularly along the axis perpendicular to the axis formed by the pump laser **22'.** To optimize symmetry in the laser medium body **C,** the laser medium body **C** should have absorption properties conducive for creating an even distribution of absorbed energy on either side of the laser axis.

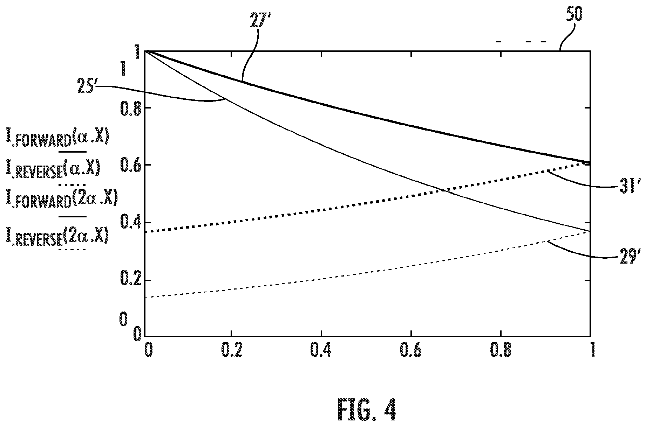

Referring now to FIG. 4, a plot **50** of normalized intensity for forward and backward round-trip propagation within the laser medium body **C** for two different pump absorption values is provided. The solid line **25'** represents forward propagation along the longitudinal axis in the laser medium body **C,** and the corresponding dashed line **29'** represents the recirculation path for reverse propagation. The solid line **27'** represents forward propagation for the marginal rays in the laser medium body **C,** and the corresponding dashed line **31'** represents the recirculation path for reverse propagation.

The y-axis is transmission of the beam, and the x-axis is the width of the laser medium body **C.** The plot **50'** demonstrates the effect of absorption of the beam within the laser medium **C** as the beam propagates through a width of the laser medium body **C.**

More particularly, the plot shows the width normalized round-trip pump absorption versus propagation distance in the laser medium body **C** for absorption coefficients of V = 0.5 and 1.0. In both cases, there is residual energy for a round-trip through an arbitrary absorbing medium.

As can be demonstrated, strong absorption will lead to greater asymmetry in one-sided pump absorption, whereas weak absorption will lead to greater symmetry. However, for the weaker absorption case the pump light may make more round-trips through the laser medium body **C** for it to be absorbed at an amount comparable to the stronger absorption case. In this latter case, alignment and reflectivities of the pump recirculating elements may need to be considered more strongly.

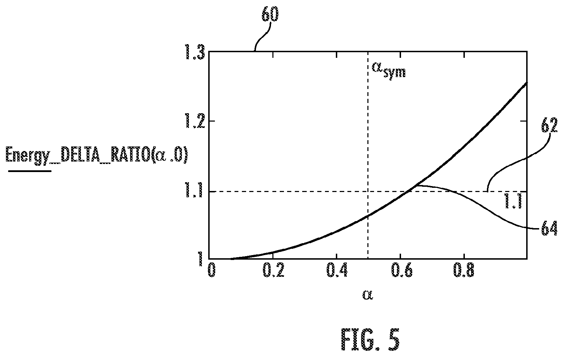

Referring now to FIG. 5, a plot **60** of a figure-of-merit for asymmetric pump absorption is provided. A ratio of forward to backward propagating pump absorption on either side of the laser axis (y-axis) is given as a function of the absorption coefficient V (x-axis). A notional limit of 1.1 corresponding to dashed line **62** is displayed on the plot **60** indicating the absorption coefficient V should be no larger than approximately 0.6 corresponding to point **64.**

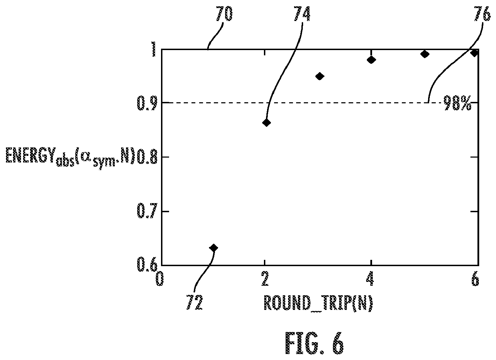

Referring now to FIG. 6, a plot **72** showing the pump energy absorbed versus a number of round-trips through the laser medium body **B** is provided. Diamond **72** represents 1 round-trip whereas diamond **74** represents 2 round-trips. The number of round-trips incrementally increase with the remaining diamonds.

An arbitrary figure of merit of 90%, as represented by dashed line **76,** is such that the maximum number of round-trips through the laser medium body **C** should be managed. In the plot **70,** 2 round-trips should be managed for high efficiency. The pump optical system design may need to be configured in such a way as to avoid recirculating the pump light into the laser pump **A.**

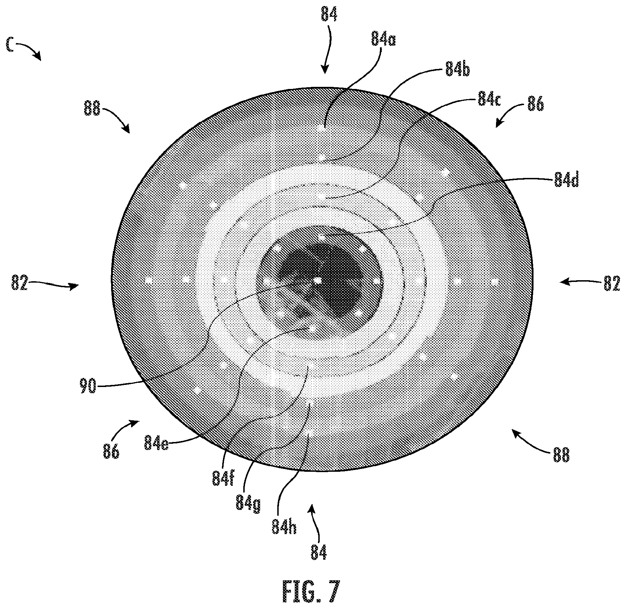

Referring now to FIG. 7, an enlarged cross-sectional view of the laser medium body **C** as shown in FIG. 3 depicts a radially-symmetric and intensity varying pump mode. Each concentric ring in the cross-section represents a respective intensity of the desired laser spatial mode.

The center ring has the highest intensity value and the outermost ring has the lowest intensity value. The intensity values of the middle rings incrementally decrease between the highest and lowest intensity values.

As noted above, the merit function includes target absorption values defining a desired symmetrical absorption profile of the laser beam passing through the laser medium body **C.** In particular, the target absorption values represent an absorbed flux of the laser beam passing through the laser medium body **C.**

In the cross-sectional view, a plurality of points illustrated as squares are spread uniformly over different axes of the mode profile. Point **90** is in the center of the the cross-sectional view. There are points are along the horizontal axis **82,** the vertical axis **84,** and a pair of diagonal axes **86** and **88.** The vertical axis **84,** for example, includes points **84a-84h.** Although not labeled, the points on the horizontal axis 82 and the diagonal axes **86, 88** are uniformly spaced and would have similar reference markings for each respective axis. Additional points may be added to further define the desired laser mode for greater radial symmetry.

Each point is assigned a discrete target absorption value. Collectively, the discrete target absorption values define the desired symmetrical absorption profile. For greater resolution, additional points may be added resulting in additional calculations by the optical model.

The resultant symmetrical absorption profile may appear as a bow tie shape within the cross-sectional view **80,** for example. The absorbed flux values of the points are selected to generally define a smooth radially-symmetric profile.

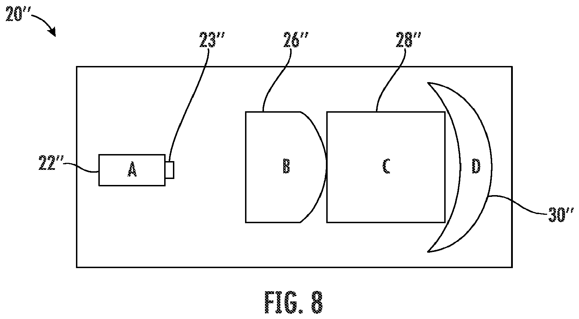

For illustration purposes, the desired symmetrical absorption profile is to be obtained using the resonator components for the single-sided pumped laser device **20"** illustrated in cross-section in FIG. 8. The resonator components include the laser pump **A,** the transmissive optic **B,** the laser medium **C** and the reflector **D.** The optical model uses the merit function to correct for pump light distribution asymmetry by determining tilts, spacings and surface shape modifications of these resonator components.

A starting point is to determine the initial relative spacings among the resonator components, as reflected by positioning of the resonator components in FIG. 8. Determination of the adjusted relative spacings will be constrained by the size of the device that is to include the single-sided pumped laser device **20",** such as a hand-held laser rangefinder.

The laser medium body **C** is to have a rectangular shape with an absorption coefficient of 0.50. The divergence angles of the pump light from the laser pump **A** has a fast axis divergence angle of 30 degrees, and a slow axis divergence angle of 10 degrees. The divergence angles are full width at half maximum (FWHM), single mode.

The optical model determines a plurality of computed absorption profiles, with each computed absorption profile comprising a plurality of computed absorption values corresponding to the plurality of target absorption values. In other words, absorbed flux values for the points in FIG. 7 are calculated by the optical model for computed absorption values.

The optical model determines the plurality of computed absorption profiles while varying curvature of the transmissive optic **B** and the reflector **D,** and varying relative spacings among the laser medium body **C,** the laser pump **B,** the transmissive optic **B** and the reflector **D.**

The merit function compares, for each computed absorption profile, the plurality of computed absorption values to the plurality of target absorption values. The merit function is computed as follows:

$$MF^2 = \frac{\sum W_i (V_i - T_i)^2}{\sum W_i}$$

$W_i$ is the weight of an $i^{th}$ operand, $V_i$ is its computed absorption value, and $T_i$ is the corresponding target absorption value. The summation is over all of the operands in the merit function. As the computed absorption values of the operands move towards their target absorption values, the function value approaches zero. Because the difference between the target absorption values T and the computed absorption values V of each operand is squared, any deviation from the target absorption value yields an increasingly positive value of the merit function.

The merit function determines, for each computed absorption profile, a difference between the plurality of computed absorption values and the corresponding plurality of target absorption values, with the differences for each computed absorption profile being summed together to define a respective merit function value.

The optical model defines a plurality of respective merit function values ranging from high to low. A goal of the optical model is to reduce the merit function to 0, or as close as possible, by varying curvature of the transmissive optic **B** and the reflector **D,** and varying relative spacings among the laser medium body **C,** the laser pump **B,** the transmissive optic **B** and the reflector **D.**

**TABLE 1**

| Element | Position Relative To Center Of C | Half Height | Surface Radii | Index Of Refraction Relative To Air = 1 | Thickness |
|---|---|---|---|---|---|
| A | -4.108 | N/A | N/A | N/A | N/A |
| B | -2.333 | 1 | Infinity/1.449 | 1.509 | 1.333 |
| C | 0 | 1 | Infinity | N/A | N/A |
| D | 1.349 | 1.333 | 1.941 | N/A | N/A |

Example dimensionless curvatures and relative spacing values as have been determined by the optical model optimization are provided above in TABLE 1. The resonator elements **A-D** are listed in the first column. The second column provides the relative spacings for the resonator components. The spacings are relative to the center of the laser medium body **C.** The third column provides the half-height of elements **B, C** and **D.** The half-heights are provided for compatibility with ray-tracing optical software ray clearance requirements.

The curvature of elements **B** and **D** are provided in the fourth column. Since element **C** has a rectangular shape, the curvature is listed as infinity which corresponds to a flat surface. For element B, one side is flat and the opposing side has a curvature radius of 1.449. The curvature of element D has a curvature radius of 1.941. The fifth column provides the index of refraction for element **B.** In the last column, a thickness of element **B** is provided.

The resonator components for the single-sided pumped laser device **20"** are to be assembled using the curvature of the transmissive optic **B** and the reflector **D** based on TABLE 1, and the adjusted relative spacings among the laser medium body **C,** the laser pump **B,** the transmissive optic **B** and the reflector **D** as also based on TABLE 1. In other embodiments, rotating or tilting of the resonator components may also be taken into consideration by the optical model.

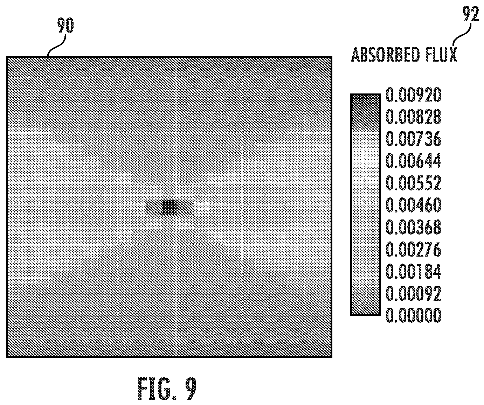

Referring now to FIG. 9, a plot **90** of the absorbed flux for the laser medium body **C** after operating the optical model based on the merit function is provided. Next to the plot **90** are corresponding absorbed flux values **92.** The absorbed flux is based on a linear scale with arbitrary units. The pump light distribution within the laser medium body **C** has a bow tie shape that is symmetrical with respect to the longitudinal axis.

The pump absorption asymmetry along the horizontal axis for this configuration is 1.6% using the definition of (LH - RH)/(2 * (LH + RH), where LH is all summed absorbed flux to the left of the center of the laser medium body **C** and RH is all absorbed flus to the right of the laser medium body **C.** By design, the vertical axis is symmetrical.

Another aspect is directed to a non-transitory computer readable medium for operating a computing device comprising a display and processor coupled to the display, and with the non-transitory computer readable medium having a plurality of computer executable instructions for causing the processor to perform a series of steps. The steps include receiving as input an absorption coefficient for a laser medium body **28,** and receiving as input divergence angles of pump light **24** from a laser pump **22** to be directed at a side of the laser medium body **28.**

The steps further include receiving as input initial relative spacings of at least one reflector **30** for the pump light with respect to the laser medium body **28** and the laser pump **22,** and receiving as input a merit function defining a desired absorption profile of the pump light passing through the laser medium body **28.**

An optical model is operated based on the received merit function and the received absorption coefficient, divergence angles and initial relative spacings to determine a curvature of the at least one reflector **30,** adjusted relative spacings among the laser medium body **28,** the laser pump **22,** and the at least one reflector **30.** The determined curvature of the at least one reflector **30** and the adjusted relative spacings to be used are displayed to make the single-sided pumped laser device **20.**

**Claims**

1. A method (300) for making a single-sided pumped laser device comprising:

    determining (304) an absorption coefficient for a laser medium body;
    determining (308) divergence angles of pump light from a laser pump to be directed at a side of the laser medium body;
    determining (308) initial relative spacings of at least one reflector for the pump light with respect to the laser medium body and the laser pump;
    generating (310) a merit function defining a desired absorption profile of the pump light passing through the laser medium body;
    using a processor and an associated memory to operate (314) an optical model based on the merit function and the determined absorption coefficient, divergence angles and initial relative spacings to determine the following:

        a curvature of the at least one reflector (314), and
        adjusted relative spacings among the laser medium body (316), the laser pump, and the at least one reflector; and
        assembling (318) the laser medium body, the laser pump, and the at least one reflector according to the determined curvature of the at least one reflector and the adjusted relative spacings to make the single-sided pumped laser device,
        wherein the method is **characterized in that**
        the single-sided pumped laser device comprises ancillary reflectors (E) that are configured to reflect residual pump light, which is reflected by the at least one reflector (D), to the laser medium body (C) along an axis, which is perpendicular to an emission axis of the laser pump (A).

2. The method (300) according to Claim 1 wherein the merit function comprises a plurality of target absorption values defining the desired absorption profile.

3. The method (300) according to Claim 2 wherein the optical model determines a plurality of computed absorption profiles, with each computed absorption profile comprising a plurality of computed absorption values corresponding to the plurality of target absorption values.

4. The method (300) according to Claim 3 wherein the optical model determines the plurality of computed absorption profiles while varying curvature of the at least one reflector and varying relative spacings among the laser medium body, the laser pump and the at least one reflector.

5. The method (300) according to Claim 3 wherein the merit function compares, for each computed absorption profile, the plurality of computed absorption values to the plurality of target absorption values.

6. The method (300) according to Claim 5 wherein the merit function determines, for each computed absorption profile, a difference between the plurality of computed absorption values and the corresponding plurality of target absorption values, with the differences for each computed absorption profile being summed together to define a respective merit function value.

7. The method (300) according to Claim 6 wherein the optical model defines a plurality of respective merit function values ranging from high to low, with the single-sided pumped laser device being assembled using the curvature of the at least one reflector and the relative spacings among the laser medium body, the laser pump and the at least one reflector for the merit function value having the lowest value.

**8.** The method (300) according to Claim 1 wherein the laser pump comprises a laser diode.

**9.** A non-transitory computer readable medium for operating a computing device comprising a display and processor coupled to the display, and with the non-transitory computer readable medium having a plurality of computer executable instructions for causing the processor to perform the method according to Claim 1.

**10.** The non-transitory computer readable medium according to Claim 9 wherein the desired absorption profile of the pump light is symmetrical to a centerline of the laser medium body.

**Patentansprüche**

**1.** Ein Verfahren (300) zur Herstellung einer einseitig gepumpten Laseranordnung, umfassend:

Bestimmen (304) eines Absorptionskoeffizienten für einen Lasermediumkörper;
Bestimmen (308) von Divergenzwinkeln von Pumplicht von einer Laserpumpe, das auf eine Seite des Lasermediumkörpers gerichtet werden soll;
Bestimmen (308) anfänglicher relativer Abstände mindestens eines Reflektors für das Pumplicht in Bezug auf den Lasermediumkörper und die Laserpumpe;
Erzeugen (310) einer Bewertungsfunktion, die ein gewünschtes Absorptionsprofil des durch den Lasermediumkörper hindurchtretenden Pumplichtstrahls definiert;
Verwenden eines Prozessors und eines zugehörigen Speichers zum Betreiben (314) eines optischen Modells auf der Grundlage der Bewertungsfunktion und des ermittelten Absorptionskoeffizienten, der Divergenzwinkel und der anfänglichen relativen Abstände, um Folgendes zu bestimmen:

eine Krümmung des mindestens einen Reflektors (314) und
angepasste relative Abstände zwischen dem Lasermediumkörper (316), der Laserpumpe und dem mindestens einen Reflektor; und
Zusammenbau (318) des Lasermediumkörpers, der Laserpumpe und des mindestens einen Reflektors gemäß der ermittelten Krümmung des mindestens einen Reflektors und den angepassten relativen Abständen, um die einseitig gepumpte Laservorrichtung herzustellen,
wobei das Verfahren **dadurch gekennzeichnet ist, dass**
die einseitig gepumpte Laservorrichtung Hilfsreflektoren (E) umfasst, die so konfiguriert sind, dass sie Restpumplicht, das von dem mindestens einen Reflektor (D) reflektiert wird, entlang einer Achse, die senkrecht zu einer Emissionsachse der Laserpumpe (A) steht, zu dem Lasermediumkörper (C) reflektieren.

**2.** Das Verfahren (300) nach Anspruch 1, wobei die Leistungsfunktion eine Vielzahl von Zielabsorptionswerten umfasst, die das gewünschte Absorptionsprofil definieren.

**3.** Das Verfahren (300) nach Anspruch 2, wobei das optische Modell eine Vielzahl von berechneten Absorptionsprofilen bestimmt, wobei jedes berechnete Absorptionsprofil eine Vielzahl von berechneten Absorptionswerten umfasst, die der Vielzahl von Zielabsorptionswerten entsprechen.

**4.** Das Verfahren (300) nach Anspruch 3, wobei das optische Modell die Vielzahl berechneter Absorptionsprofile bestimmt, während die Krümmung von des mindestens einen Reflektors variiert wird und die relativen Abstände zwischen dem Lasermediumkörper, der Laserpumpe und dem mindestens einen Reflektor variiert werden.

**5.** Das Verfahren (300) nach Anspruch 3, wobei die Bewertungsfunktion für jedes berechnete Absorptionsprofil die Vielzahl berechneter Absorptionswerte mit der Vielzahl von Zielabsorptionswerten vergleicht.

**6.** Das Verfahren (300) nach Anspruch 5, wobei die Bewertungsfunktion für jedes berechnete Absorptionsprofil eine Differenz zwischen der Vielzahl berechneter Absorptionswerte und der entsprechenden Vielzahl von Zielabsorptionswerten bestimmt, wobei die Differenzen für jedes berechnete Absorptionsprofil addiert werden, um einen entsprechenden Bewertungsfunktionswert zu definieren.

**7.** Das Verfahren (300) nach Anspruch 6, wobei das optische Modell mehrere jeweilige Leistungsfunktionswerte definiert, die von hoch bis niedrig reichen, wobei die einseitig gepumpte Laservorrichtung unter Verwendung der Krümmung des mindestens einen Reflektors und der relativen Abstände zwischen dem Lasermediumkörper, der Laserpumpe und dem mindestens einen Reflektor für den Leistungsfunktionswert mit dem niedrigsten Wert zusammengebaut wird.

**8.** Das Verfahren (300) nach Anspruch 1, wobei die Laserpumpe eine Laserdiode umfasst.

**9.** Ein nichtflüchtiges, computerlesbares Medium zum Betreiben einer Recheneinrichtung, die eine Anzeige und einen mit der Anzeige gekoppelten Prozessor umfasst, wobei das nichtflüchtige, computerlesbare Medium eine Vielzahl von computerausführbaren Befehlen aufweist, um den Prozessor zu veranlassen, das Verfahren gemäß Anspruch 1 auszuführen.

**10.** Das nicht-transitorische, computerlesbare Medium gemäß Anspruch 9, wobei das gewünschte Absorptionsprofil des Pumpenlichts symmetrisch zu einer Mittellinie des Lasermediumkörpers ist.

**Revendications**

**1.** Une méthode (300) d' t de fabrication d'un dispositif laser à pompage unilatéral comprenant:

la détermination (304) d'un coefficient d'absorption pour un corps de milieu laser;
la détermination (308) des angles de divergence de la lumière de pompage provenant d'une pompe laser à diriger vers un côté du corps de milieu laser;
déterminer (308) des espacements relatifs initiaux d'au moins un réflecteur pour la lumière de pompage par rapport au corps de milieu laser et à la pompe laser;
générer (310) une fonction de mérite définissant un profil d'absorption souhaité de la lumière de pompage traversant le corps de milieu laser;
utiliser un processeur et une mémoire associée pour faire fonctionner (314) un modèle optique basé sur la fonction de mérite et le coefficient d'absorption déterminé, les angles de divergence et les espacements relatifs initiaux afin de déterminer les éléments suivants:

une courbure d'au moins un réflecteur (314), et
les espacements relatifs ajustés entre le corps du milieu laser (316), la pompe laser et le au moins un réflecteur; et
assembler (318) le corps du milieu laser, la pompe laser et le au moins un réflecteur selon la courbure déterminée du au moins un réflecteur et les espacements relatifs ajustés pour fabriquer le dispositif laser à pompage unilatéral,
le procédé étant **caractérisé en ce que**
le dispositif laser à pompage unilatéral comprend des réflecteurs auxiliaires (E) qui sont configurés pour réfléchir la lumière de pompage résiduelle, qui est réfléchie par le ou les réflecteurs (D), vers le corps de milieu laser (C) le long d'un axe qui est perpendiculaire à un axe d'émission de la pompe laser (A).

**2.** La méthode (300) selon la revendication 1, dans laquelle la fonction de mérite comprend une pluralité de valeurs d'absorption cibles définissant le profil d'absorption souhaité.

**3.** La méthode (300) selon la revendication 2, dans laquelle le modèle optique détermine une pluralité de profils d'absorption calculés, chaque profil d'absorption calculé comprenant une pluralité de valeurs d'absorption calculées correspondant à la pluralité de valeurs d'absorption cibles.

**4.** La méthode (300) selon la revendication 3, dans laquelle le modèle optique détermine la pluralité de profils d'absorption calculés tout en faisant varier la courbure de l' ant le au moins un réflecteur et en faisant varier les espacements relatifs entre le corps du milieu laser, la pompe laser et le au moins un réflecteur.

**5.** La méthode (300) selon la revendication 3, dans laquelle la fonction de mérite compare, pour chaque profil d'absorption calculé, la pluralité de valeurs d'absorption calculées à la pluralité de valeurs d'absorption cibles.

**6.** La méthode (300) selon la revendication 5, dans laquelle la fonction de mérite détermine, pour chaque profil d'absorption calculé, une différence entre la pluralité de valeurs d'absorption calculées et la pluralité correspondante de valeurs d'absorption cibles, les différences pour chaque profil d'absorption calculé étant additionnées pour définir une valeur de fonction de mérite respective.

7. La méthode (300) selon la revendication 6, dans laquelle le modèle optique définit une pluralité de valeurs de fonction de mérite respectives allant de haute à basse, le dispositif laser à pompage unilatéral étant assemblé en utilisant la courbure d'au moins un réflecteur et les espacements relatifs entre le corps de milieu laser, la pompe laser et au moins un réflecteur pour la valeur de fonction de mérite ayant la valeur la plus basse.

8. La méthode (300) selon la revendication 1, dans laquelle la pompe laser comprend une diode laser.

9. Un support non transitoire lisible par ordinateur pour faire fonctionner un dispositif informatique comprenant un écran et un processeur couplé à l'écran, le support non transitoire lisible par ordinateur comportant une pluralité d'instructions exécutables par ordinateur pour amener le processeur à exécuter le procédé selon la revendication 1.

10. Le support informatique non transitoire lisible par ordinateur selon la revendication 9, dans lequel le profil d'absorption souhaité de la lumière de pompage est symétrique par rapport à une ligne centrale du corps du milieu laser.

FIG. 1A

FIG. 1B

302 — START

300

304 — DETERMINING AN ABSORPTION COEFFICIENT FOR A LASER MEDIUM BODY

306 — DETERMINING DIVERGENCE ANGLES OF PUMP LIGHT FROM A LASER PUMP TO BE DIRECTED AT A SIDE OF THE LASER MEDIUM BODY

308 — DETERMINING INITIAL RELATIVE SPACINGS OF AT LEAST ONE REFLECTOR FOR THE PUMP LIGHT WITH RESPECT TO THE LASER MEDIUM BODY AND THE LASER PUMP

310 — GENERATING A MERIT FUNCTION DEFINING A DESIRED ABSORPTION PROFILE OF THE PUMP LIGHT PASSING THROUGH THE LASER MEDIUM BODY

312 — INPUTTING THE MERIT FUNCTION AND THE DETERMINED ABSORPTION COEFFICIENT, DIVERGENCE ANGLES AND INITIAL RELATIVE SPACINGS INTO AN OPTICAL MODEL

314 — OPERATING THE OPTICAL MODEL TO DETERMINE CURVATURE OF THE AT LEAST ONE REFLECTOR

316 — OPERATING THE OPTICAL MODEL TO DETERMINE AN ADJUSTED RELATIVE SPACING AMONG THE LASER MEDIUM BODY, THE LASER PUMP, AND THE AT LEAST ONE REFLECTOR

318 — ASSEMBLING THE LASER MEDIUM BODY, THE LASER PUMP, AND THE AT LEAST ONE REFLECTOR ACCORDING TO THE DETERMINED CURVATURE AND ADJUSTED RELATIVE SPACINGS TO MAKE THE SINGLE-SIDED PUMP LASER DEVICE

320 — END

**FIG. 2**

FIG. 3

$$I_{.FORWARD}(\alpha.X)$$
$$I_{.REVERSE}(\alpha.X)$$
$$I_{.FORWARD}(2\alpha.X)$$
$$I_{.REVERSE}(2\alpha.X)$$

FIG. 4

15

FIG. 5

FIG. 6

FIG. 7

FIG. 8

FIG. 9

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 8320425 B1

- US 2023028158 A1

**Non-patent literature cited in the description**

- **WALMSLEY IAN A**. Non-edge-ray design: improved optical pumping of lasers. *Optical Engineering*, 01 July 2004, vol. 43 (7), 1511
- **KOSHEL R et al.** Diode Side Pumping of an Nd:YAG Laser Rod with a Nonimaging Pump Cavity. *International Optical Design Conference*, 01 January 1994, NISL304
- **KOSHEL R et al.** Modeling of the gain distribution for diode pumping of a solid-state laser rod with nonimaging optics. *Applied Optics*, 20 March 1993, vol. 32 (9), 1517

- Diode pumping of a solid-state laser rod by a two-dimensional CPC-elliptical cavity with intervening optics. **LIANG et al.** OPTICS COMMUNICATIONS. ELSEVIER, 10 May 2007, vol. 275, 104-115
- **YI JONGHOON et al.** Diode-Pumped Nd: YAG Rod Laser with Single-Side Pumping Geometry. *Journal of the Korean Physical Society*, 13 August 2010, vol. 57 (2), 355-358